# EUROPEAN PATENT APPLICATION

(11) **EP 4 701 081 A1**
(43) Date of publication of application: **25.02.2026**
(21) Application number: 25190852.1
(22) Date of filing: 22.07.2025
(51) Int. Cl.: H03K 19/003

(54) **ENHANCED DEGRADATION CIRCUIT**

(30) Priority: 20.08.2024 US 202418810404
(71) Applicant: NXP B.V., 5656 AG Eindhoven (NL)
(72) Inventor: Verhoeven, Henri, 5656AG Eindhoven (NL); Moonen, Oswald, 5656AG Eindhoven (NL); Lammers, Thieu, 5656AG Eindhoven (NL)
(74) Representative: Colaiuda, Antonella

(57) **Abstract**

One example discloses a degradation circuit, including: a first set of structures configured to be coupled to a semiconductor package; a second set of structures, coupled to the first set of structures, and configured to be coupled to the package; wherein together the first and second set of structures form a Wheatstone bridge within a degradation detection element; and a controller, coupled to the degradation detection element, and configured to set an operational state of an integrated circuit (IC) within the package based on the degradation detection element.

## Description

The present specification relates to systems, methods, apparatuses, devices, articles of manufacture and instructions for detecting and remediating degradation in chips and/or chip packages.

### SUMMARY

According to an example embodiment, a degradation circuit, comprising: a first set of structures configured to be coupled to a semiconductor package; a second set of structures, coupled to the first set of structures, and configured to be coupled to the package; wherein together the first and second set of structures form a Wheatstone bridge within a degradation detection element; and a controller, coupled to the degradation detection element, and configured to set an operational state of an integrated circuit (IC) within the package based on the degradation detection element.

In another example embodiment, the controller is configured to set the operational state of the IC to fully functional if the degradation detection element indicates a value is within a first predetermined range.

In another example embodiment, the controller is configured to set the operational state of the IC to partially functional if the degradation detection element indicates the value is within a second predetermined range.

In another example embodiment, the controller is configured to set the operational state of the IC to non-functional if the degradation detection element indicates the value is within a third predetermined range.

In another example embodiment, the Wheatstone bridge includes a set of four capacitors formed by the first set of structures and the second set of structures.

In another example embodiment, the degradation detection element includes a dielectric layer coupled between the first and second set of structures; the first set of structures is a first metal region; and the second set of structures is a second metal region.

In another example embodiment, the controller is configured to set the operational state of the IC only while the IC is powered and actively operating.

In another example embodiment, the controller is configured to select a remediation action for the IC based on the operational state.

In another example embodiment, the remediation action includes shutting down a sub-set of circuits within the IC.

In another example embodiment, the remediation action includes shutting down a first set of functionality within the IC and keeping a second set of functionality within the IC operating.

In another example embodiment, the remediation action includes shutting down the IC's command and control functionality while keeping the IC's collection and transmission of sensor data operating.

In another example embodiment, the remediation action includes executing a power on reset (POR) of the IC.

In another example embodiment, the remediation action includes activating a set of self-healing circuits within the IC that are configured to repair the detected degradation; and the self-healing circuits include a self-healing circuit configured to heat the IC and melt a self-healing material.

In another example embodiment, the remediation action includes at least one of: transmitting the operational state to a set of devices networked with the IC; activating a back-up circuit in the IC; and activating a set of enhanced IC monitoring tools.

In another example embodiment, the second set of structures includes a set of sub-structures; the set of sub-structures are coupled to different portions of the IC; together the first and the set of sub-structures form a set of degradation detection elements; and the controller is coupled to the set of degradation detection elements, and is configured to set an operational state for each of the different portions of the IC based on the set of degradation detection elements.

In another example embodiment, the controller is configured to select a different remediation action for each of the different portions of the IC corresponding to that portion's operational state.

In another example embodiment, the controller is configured to set an operational state, for at least one of the different portions of the IC, to non-functional, if the degradation detection elements associated with that portion of the IC has a value is within a predetermined range.

In another example embodiment, the controller is configured to shut down the different portions of the IC having the non-functional operational state.

In another example embodiment, the semiconductor package includes a set of ICs; the controller is configured to set a first IC having a first robustness level to a first operational state if the degradation detection element has a value is within a predetermined range; and the controller is configured to set a second IC having a second robustness level to a second operational state, different from the first operational state, if the degradation detection element has the value is within the predetermined range.

In another example embodiment, the controller is configured to identify a robustness level of the IC; the robustness level of the IC has a first value if the IC is designed to be least susceptible to degradation; the robustness level of the IC has a second value if the IC is designed to be less susceptible to degradation; and the robustness level of the IC has a third value if the IC is most susceptible to degradation.

In another example embodiment, the degradation circuit and the IC are both configured to powered by a same power supply.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

Figure 1 represents an example prior art semiconductor device (e.g. IC chip).
Figure 2 represents a first example semiconductor device with degradation monitoring.
Figure 3 represents a second example semiconductor device with degradation monitoring.
Figure 4 represents a third example semiconductor device with degradation monitoring.
Figures 5A and 5B represent a first example degradation circuit within either the first, second or third example semiconductor devices.
Figure 6 represents a second example degradation circuit within either the first, second or third example semiconductor devices.
Figure 7 represents a third example degradation circuit within either the first, second or third example semiconductor devices.
Figure 8 represents an example set of controller logic within either the first, second or third example degradation circuits.
Figure 9 represents a fourth example semiconductor device with degradation monitoring.
Figure 10 represents an example degradation circuit within the fourth example semiconductor device.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the scope of the appended claims are covered as well.

### DETAILED DESCRIPTION

Semiconductor devices and other circuits during a normal course of their service life are susceptible to gradual and/or catastrophic failure. Manufacturers often base such device and circuit service life predictions on statistical failure rate data collected during testing and sometimes supplemented by in the field data from customers.

Such failure rate data is driven by the operating, environmental, and/or application conditions in which such devices and/or circuits are used.

For example device and circuit failures can be caused by: operating conditions (e.g. repeated heating and cooling, high-current fusing, etc.); environmental factors (e.g. exposure to water, humidity, salt, UV, weathering, chemicals, etchants, radiation, etc.); and/or acute damage (e.g. shock, cracks, mechanical, chemical, radiation, etc.).

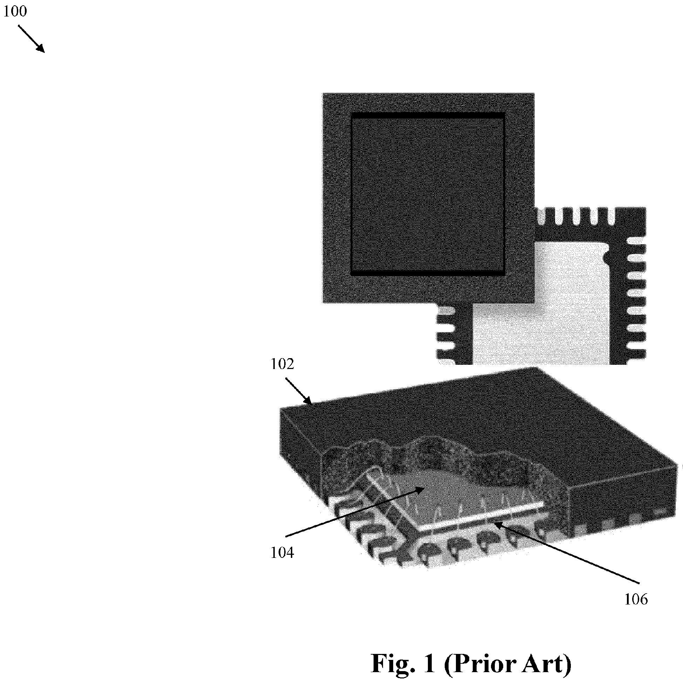

Figure 1 represents an example prior art semiconductor device 100 (e.g. integrated circuit (IC) chip), that is susceptible to the operating, environmental and application conditions failures discussed above. The first example semiconductor device 100 at least includes an encapsulation material 102, an integrated circuit (IC) 104, and a lead frame 106. In response to these failures, the semiconductor device 100 may not function as designed within its specified tolerances.

Now discussed are systems, circuits and devices configured to improve functional safety by detecting varying levels of actual or impending failure (i.e. degradation) in an integrated circuit (IC), a device, a system, etc.

In various example embodiments, once degradation has been detected a variety of remediations may be employed, including: shutting down all or a sub-set of the IC's, device's, system's, etc. functionality; informing other connected and/or networked circuits, devices, systems, etc. that the IC, device, system, etc. is degraded; and/or activating back-up circuits, self-healing measures, enhanced monitoring tools, etc. configured to maintain a lower level of functional service.

Provided below are various example embodiments of a capacitive network (e.g. Wheatstone Bridge) distributed on a semiconductor chip during fabrication and/or packaging. Thus a system in a semiconductor package is created that can detect and adjust to package degradation caused by various environmental factors during the operational life of the semiconductor device.

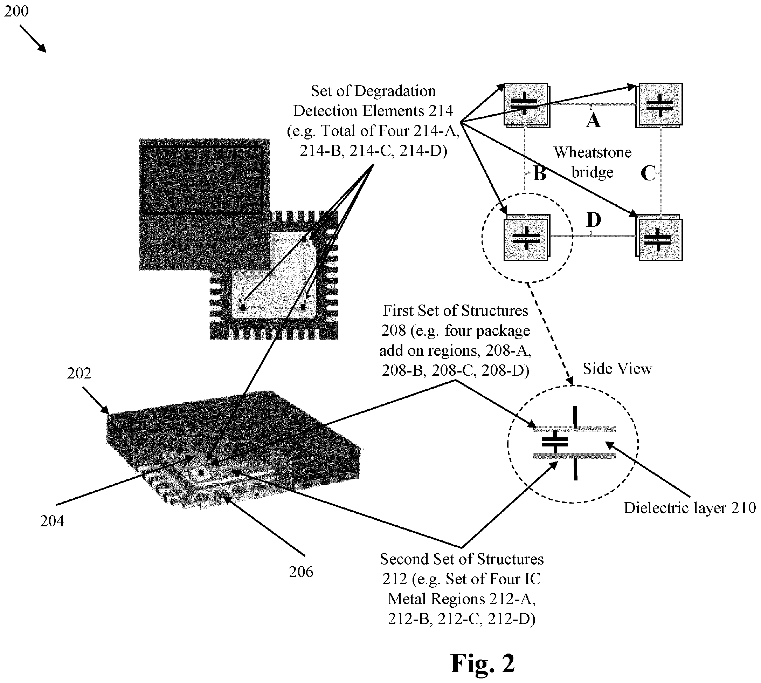

Figure 2 represents a first example semiconductor device 200 with degradation monitoring. The first example semiconductor device 200 includes an encapsulation material 202, an integrated circuit (IC) 204, and a lead frame 206. Additionally the first example semiconductor device 200 includes a first set of structures 208 (e.g. four package add-on regions that in some example embodiments do not require a separate masking process), a dielectric layer 210, and a second set of structures 212 (e.g. four existing metal regions on the IC 204).

In various example embodiments, the first set of structures 208, the dielectric layer 210, and the second set of structures 212 may individually or each include one or more sub-elements. For example, in this example embodiment the first set of structures 208 includes first, second, third and fourth add-on regions 208-A, 208-B, 208-C, 208-D, and the second set of structures 212 includes first, second, third and fourth metal regions 212-A, 212-B, 212-C, 212-D.

In some example embodiments the add-on regions 208-A, 208-B, 208-C, 208-D may be added to the second semiconductor device 200, while in other example embodiments an existing set of structures within the second semiconductor device 200 are re-used for the add-on regions 208-A, 208-B, 208-C, 208-D. Similarly, the metal regions 212-A, 212-B, 212-C, 212-D may in some example embodiments be separate from the IC 204, but in other example embodiments are an existing set of structures of the IC 204.

The first set of structures 208-A, 208-B, 208-C, 208-D, the dielectric layer 210, and the second set of structures 212-A, 212-B, 212-C, 212-D together form a set of degradation detection elements 214 (i.e. first capacitor 214-A, second capacitor 214-B, third capacitor 214-C, fourth capacitor 214-D).

While in this example embodiment the set of degradation detection elements 214 are capacitors, in other example embodiments, the set of degradation detection elements 214 may be formed using other electrical components, circuits, etc. and/or mechanical elements, switches, etc. Also, these capacitors 214-A, 214-B, 214-C, 214-D may be implemented in a variety of forms, including as a SMD, a metal ring, and a finger capacitor for cracking/tearing detection.

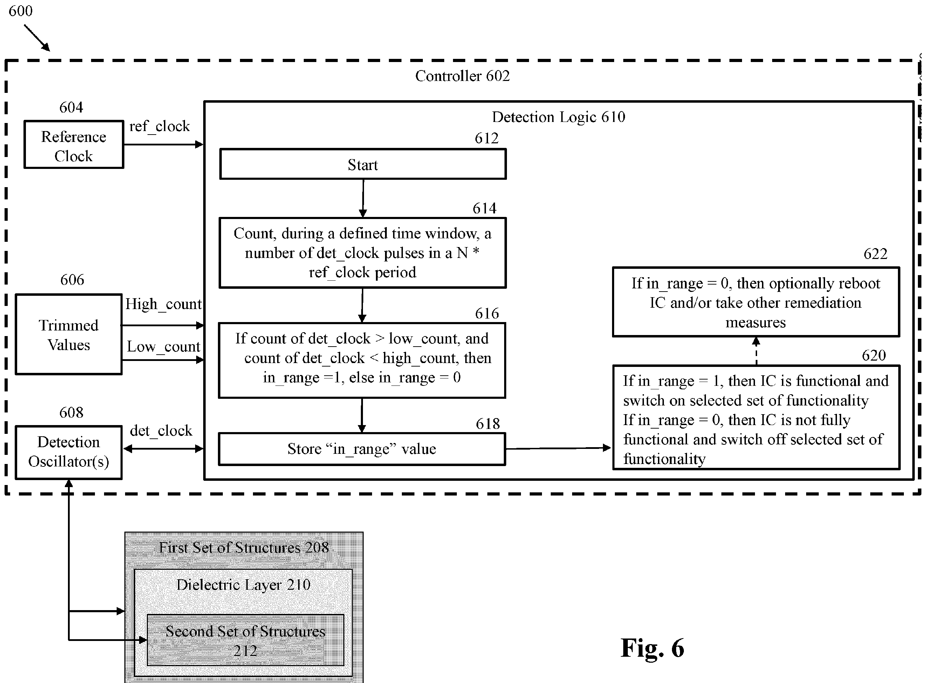

The second semiconductor device 200 also includes a controller (see Figures 6, 7, 8) embedded in IC 204. The controller is coupled to the set of degradation detection elements 214 and configured to set an operational state of the IC 204 based on a value (e.g. a variable, an on/off state, etc.) of the set of degradation detection elements 214.

In various example embodiments, the second semiconductor device 200 includes a set of packaging information, perhaps identified on an outer surface of the second semiconductor device 200 by a QR Code or encoded/programmed into the device 200, that identified a robustness level for one or more ICs in the package or for the package as a whole.

Such ICs and/or package robustness levels indicate whether the ICs and/or package is designed, for example, for a critical operating environment (e.g. an application designed to be least susceptible to degradation, such as harsh or radiation intensive space electronics); for a significant operating environment (e.g. an application designed to be less susceptible to degradation, such as for Airplanes, Auto, and Medical Electronics); or for a basic operating environment (e.g. applications most susceptible to degradation, such as for Consumer Electronics). Note, these labels (i.e. critical, significant, basic, and/or least, less, most) may be replaced with other labels and/or meaning in different example applications.

Based on such robustness level packaging information, the controller is configured to set the IC and/or package as a whole to various operational states based variations in the set of degradation detection elements 214.

For example, if an IC and/or package has a first robustness level, then the controller is configured to set the IC and/or package to a first operational state if the set of degradation detection elements 214 has a value is within a predetermined range. However, if the IC and/or package has a second robustness level, then the controller is configured to set the IC and/or package to a second operational state, different from the first operational state, even if the degradation detection element still has a same value is within the predetermined range.

Additionally, the controller can be configured to set the IC and/or package to various operational states as a value of the set of degradation detection elements 214 change over time. Thus for ICs and/or packages having different robustness levels, the controller sets the operational state in a variable manor, such that each of the ICs is remediated in a different way appropriate to their different robustness levels.

Examples of these operational states include: setting the IC and/or package to fully functional (e.g. functioning as designed and/or within operational tolerances); setting the IC and/or package to partially functional (e.g. some IC functions not as designed and/or not within operational tolerances); and setting the IC and/or package to non-functional (e.g. all or most IC functions not as designed and/or not within operational tolerances).

In various example embodiments, the set of degradation detection elements 214 may include additional sub-structures (not shown) that may be included that are coupled to different portions of the IC 204. Taken together these additional sub-structures may form additional or more complex sets of degradation detection elements. In such example embodiments, the controller is coupled to these degradation detection elements, and is configured to set an operational state of the IC and/or package based on these enhanced degradation detection elements.

In various example embodiments, the controller is further configured to select a remediation action based on these operational states. Thus in various example embodiments, the remediation action may include: shutting down a sub-set of circuits in the IC 204; transmitting the operational state to a set of devices networked with the IC 204; activating one or more back-up circuits in the IC 204; activating self-healing circuits in the IC 204; and/or activating a set of enhanced IC 204 monitoring tools.

Remediation actions may also include shutting down a set of critical IC 204 functionality and keeping a set of non-critical functionality activated; shutting down the IC's 204 command and control functionality while keeping the IC's 204 collection and transmission of sensor data activated; and/or resetting/rebooting the IC 204.

Self-healing circuits are herein defined to include circuits configured to repair the detected degradation, such as by localized heating of the IC 204 to melt a self-healing or self-sealing material.

Together, the controller and the set of degradation detection elements 214 form a degradation circuit that enables the IC 204 to have a higher level of functional safety by detecting IC 204 degradation and implementing one or more remediations.

Such IC 204 degradation is normal and common to many operating and environmental conditions. For example degradation may be caused by normal IC 204 operation over time; by an acute failure (e.g. over-specification condition, over-voltage, ESG event, thermo-stress (heat or cold); and/or when for whatever reason the IC 204 is not functioning in the right way.

One example application could be an IC in a V2X (vehicle to everything) application where the IC is mounted on a light-pole and subject to severe weather conditions. Given the importance of the IC's role in traffic safety, a complete unexpected failure of the IC could lead to traffic accidents. The degradation circuit discussed herein enables the IC degradation to be detected early and the V2X network be notified so as not to cause any unexpected failures. Other applications in electric-GRID management may prevent extensive power losses to a large city.

For those example embodiments, where the set of degradation detection elements 214 are formed by capacitors, degradation of IC will affect a value of Wheatstone Bridge capacitance measured by the controller. For example, if the IC's package has been partly or totally destroyed or degraded, then the capacitor value will be influenced by the destruction.

Such capacitor damage may be caused by caustic substances that change a size of the capacitor; radiation exposure (e.g. UV light) that effects either the first set of structures 208, the dielectric 210 and/or the second set of structures 212; capacitor has been disconnected by a crack in the first or second set of structures 208, 212; capacitor has been split up in at least two parts; capacitor has a short between two plates; thermo-stress (e.g. over heating); and/or other harsh environments.

In various example embodiments, once degradation has been detected a variety of remediations may be employed by the controller, including: shutting down all or a sub-set of the IC's, device's, system's, etc. functionality; informing other connected and/or networked circuits, devices, systems, etc. that the IC, device, system, etc. is degraded; and/or activating back-up circuits, self-healing measures, enhanced monitoring tools, etc. configured to maintain a lower level of functional service.

Shutting down functional activity may also include shutting down "critical functionality" but not "all functionality" (e.g. shut down command and control functionality but continue collection and transmission of "sensor data"). For example in some example embodiments, the IC's 204 functionality may be organized in a hierarchy from "most critical" (e.g. control systems) to "less critical" (e.g. informational/sensor) functionality working approach.)

In networked IC 204 applications a degraded IC 204 instigate a network reconfiguration, generate user alerts.

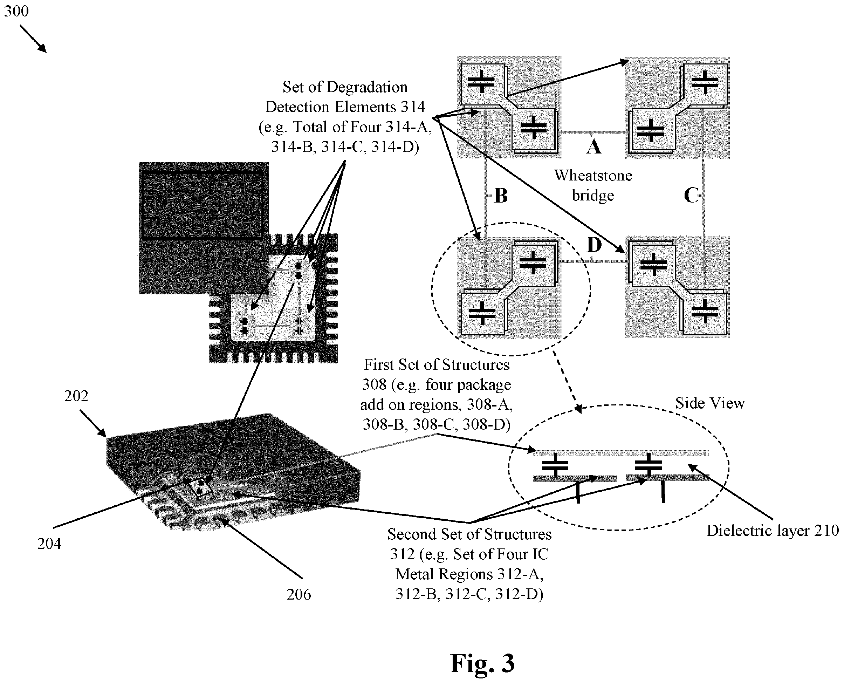

Figure 3 represents a second example semiconductor device 300 with degradation monitoring. The second example semiconductor device 300 includes an encapsulation material 202, an integrated circuit (IC) 204, and a lead frame 206. Additionally the second example semiconductor device 300 includes a first set of structures 308 (e.g. four package add-on regions), a dielectric layer 210, and a second set of structures 312 (e.g. four existing metal regions on the IC 204).

The first set of structures 308, the dielectric layer 210, and the second set of structures 312 may individually or each include one or more sub-elements. For example, in this example embodiment the first set of structures 308 includes first, second, third and fourth add-on regions 308-A, 308-B, 308-C, 308-D, and the second set of structures 312 includes first, second, third and fourth metal regions 312-A, 312-B, 312-C, 312-D.

The first set of structures 308-A, 308-B, 308-C, 308-D, the dielectric layer 210, and the second set of structures 312-A, 312-B, 312-C, 312-D together form a set of degradation detection elements 314 (i.e. first capacitor 314-A, second capacitor 314-B, third capacitor 314-C, fourth capacitor 314-D).

The second example semiconductor device 300 with degradation monitoring otherwise operates in a manner similar to the first example semiconductor device 200 discussed in Figure 2.

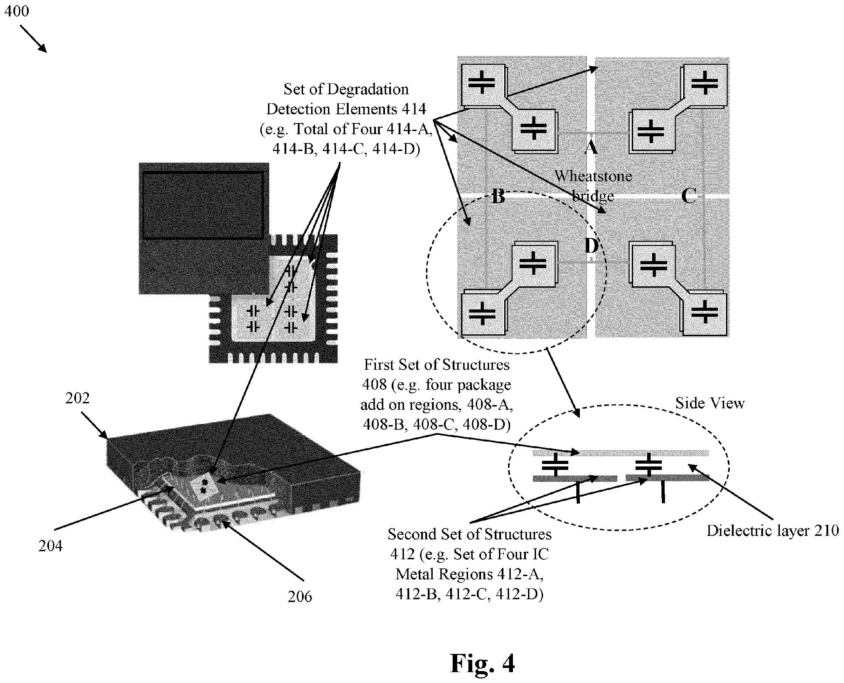

Figure 4 represents a third example semiconductor device 400 with degradation monitoring. The third example semiconductor device 400 includes an encapsulation material 202, an integrated circuit (IC) 204, and a lead frame 206. Additionally the third example semiconductor device 400 includes a first set of structures 408 (e.g. four package add-on regions), a dielectric layer 210, and a second set of structures 412 (e.g. four existing metal regions on the IC 204).

The first set of structures 408, the dielectric layer 210, and the second set of structures 412 may individually or each include one or more sub-elements. For example, in this example embodiment the first set of structures 408 includes first, second, third and fourth add-on regions 408-A, 408-B, 408-C, 408-D, and the second set of structures 412 includes first, second, third and fourth metal regions 412-A, 412-B, 412-C, 412-D.

The first set of structures 408-A, 408-B, 408-C, 408-D, the dielectric layer 210, and the second set of structures 412-A, 412-B, 412-C, 412-D together form a set of degradation detection elements 414 (i.e. first capacitor 414-A, second capacitor 414-B, third capacitor 414-C, fourth capacitor 414-D).

The third example semiconductor device 400 with degradation monitoring otherwise operates in a manner similar to the first example semiconductor device 200 discussed in Figure 2.

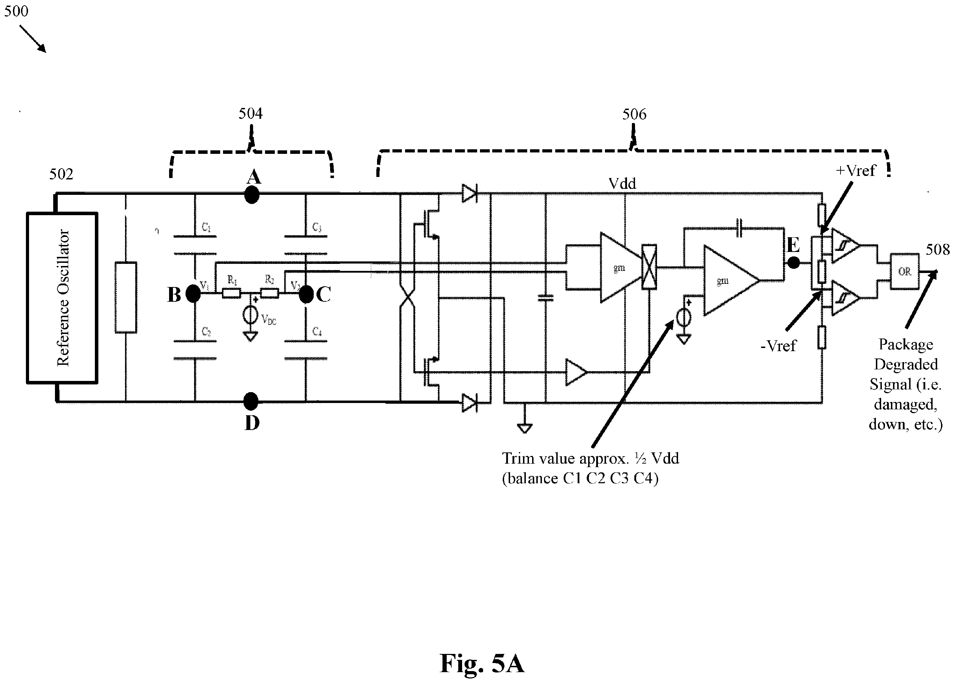

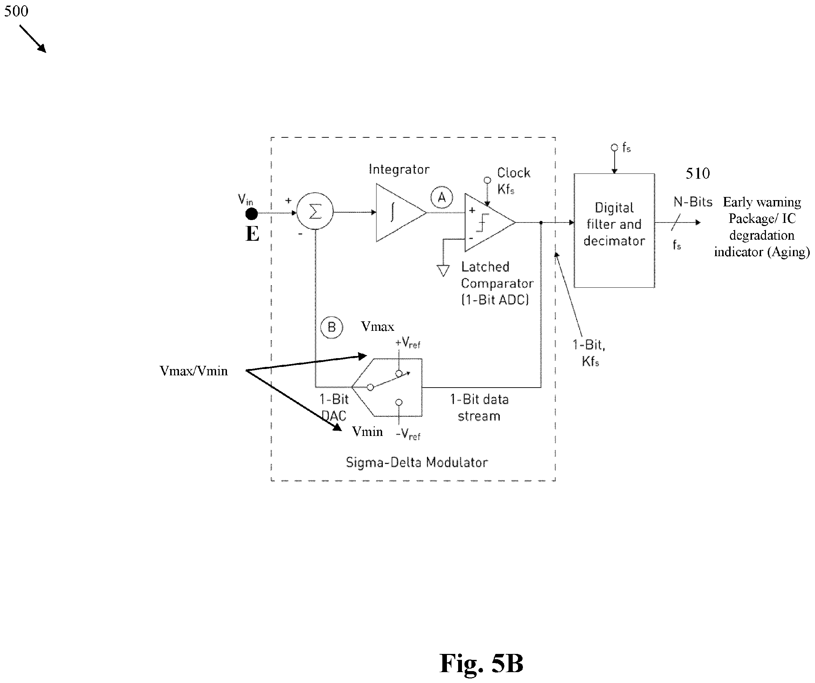

Figures 5A and 5B represent a first example degradation circuit 500 within either the first, second or third example semiconductor devices 200, 300, 400.

Figure 5A shows a first portion of the first example degradation circuit 500 and includes a reference oscillator 502, Wheatstone Bridge circuit 504 (showing connection points A, B, C, D with reference to Figures 2, 3, 4), degradation detection circuitry 506, and a first output 508. The first output 508 is configured to carry a binary package degraded signal (i.e. damaged, down, etc.).

Figure 5B shows a second portion of the first example degradation circuit 500. The second portion receives a variable signal from point "E" in Figure 5A. The second output 510 is configured to carry a variable package degraded signal that gives an earlier warning that an ID and/or package is beginning to degrade, and can be used for IC/package life-cycle prediction if the variable package degraded signal is periodically stored over time.

Figure 6 represents a second example degradation circuit 600 within either the first, second or third example semiconductor devices 200, 300, 400. The second example degradation circuit 600 includes a controller 602, a reference clock 604, a set of trimmed values 606, a detection oscillator 608, and detection logic 610.

In this example, the detection oscillator 608 uses a capacitance formed by the four Wheatstone Bridge capacitors 214 (i.e. set of degradation detection elements formed by the first set of structures 208, the dielectric layer 210, and the second set of structures 212) to set a frequency of the detection oscillator 608.

If all is normal, then the frequency of the detection oscillator 608 remains fixed or within a predetermined range of frequencies. However, if the capacitance formed by the four Wheatstone Bridge capacitors 214 changes due to degradation, then the frequency of the detection oscillator 608 changes and falls outside of the predetermined range of frequencies, thereby indicating a degraded condition of the IC 204.

For example as shown in Figure 6, the detection logic 610 receives the reference clock 604 (e.g. available on the IC); the trimmed values 606 (e.g. high_count and low_count value, one time programmed) and the detection oscillator 608.

The detection logic 610 in step 612 starts. Next in step 614, a Count (during a defined time window, a number of det _clock pulses in a N * ref_clock period) is measured. In step 616, if count of det_clock > low_count, and count of det _clock < high _count, then in_range =1, else in_range = 0. In step 618, store in_range value. In step 620, if in _range = 1, then IC is functional and switch on functionality. If in _range = 0, then IC is not fully functional and switch off functionality. Then in step 622, if in _range = 0, then optionally reboot IC and/or take other remediation measures.

In other example embodiments, instead of using the frequency of the detection oscillator 608 to detect degradation, a Q-factor amplitude (e.g. resistive losses) of the detection oscillator 608 could be used. The Q-factor amplitude will drop if the capacitor is degraded. Voltage levels are another indication.

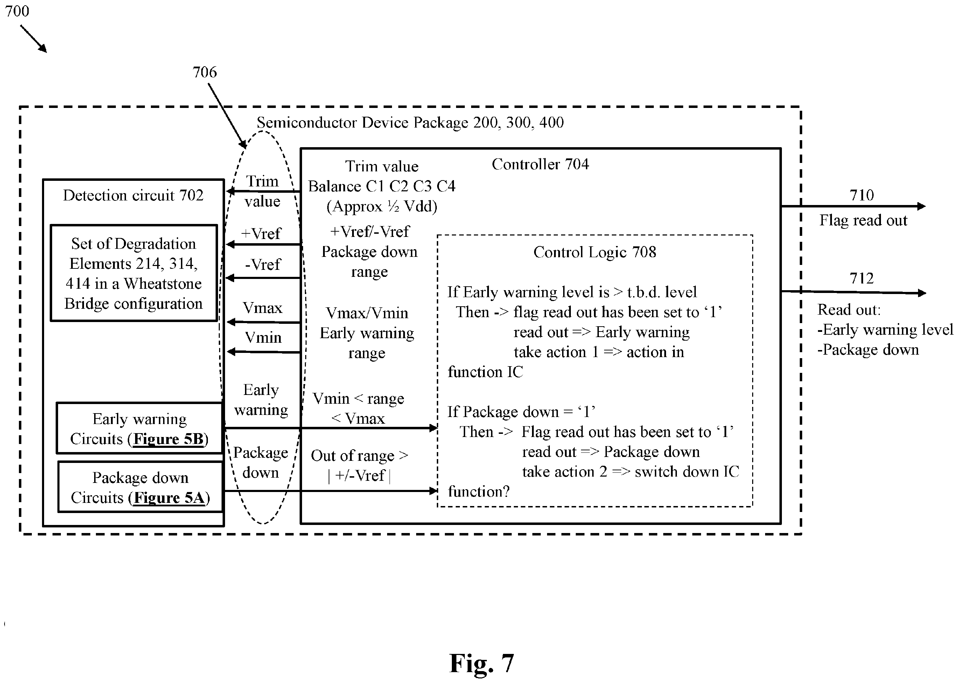

Figure 7 represents a third example degradation circuit 700 within either the first, second or third example semiconductor devices 200, 300, 400. The third example degradation circuit 700 includes a detection circuit 702 and a controller 704.

The detection circuit 702 includes the set of degradation elements 214, 314, 414 in a Wheatstone Bridge configuration, a set of package down circuits (e.g. see Figure 5A), and a set of early warning circuits (e.g. see Figure 5B).

The controller 704 exchanges a set of signals 706 with the detection circuit 702 using a set of control logic 708. Based on the set of signals 706, the control logic 708 outputs on a first output 710 a binary flag read out and on a second output 712 a package down signal and early warning level signals. The binary flag on 701 can be used as an interrupt level for an external system, that is then examines the signal on the second output 712 to determine the specific degradation condition. For example, if the early warning level is greater than a to be determined (t.b.d.) level, then the binary flag read out becomes a logic 1, which triggers an interrupt in the external system to read out the signal on the second output 712 (e.g. an early warning level, a package down signal, a partial package down signal, etc.

In an alternate embodiment, the first output 710 can be deleted, and an external system programmed to periodically poll for signals on the second output 712. Other interfaces for communicating the various degradation signals to one or more external systems may include I2C, SPI, wireless, etc. interfaces.

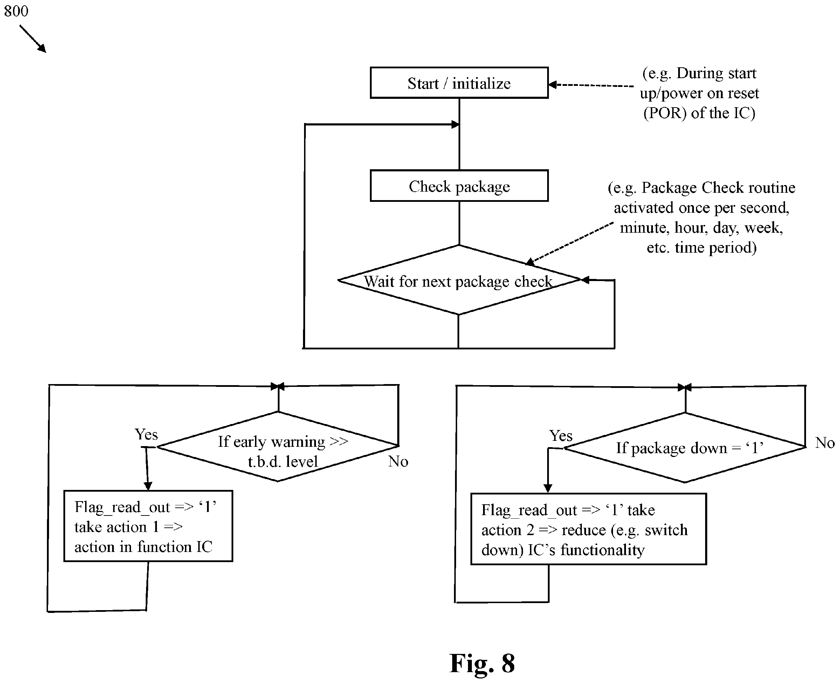

Figure 8 represents an example set of controller logic 800 within either the first, second or third example degradation circuits 200, 300, 400. The controller logic 800 can also be incorporated into the control logic 708 of Figure 7.

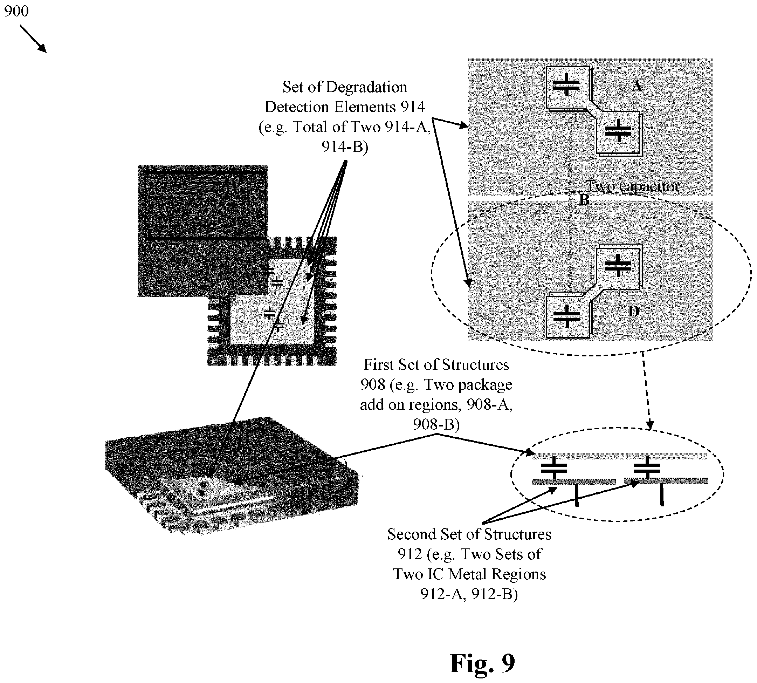

Figure 9 represents a fourth example semiconductor device 900 with degradation monitoring. The fourth example semiconductor device 900 includes an encapsulation material 202, an integrated circuit (IC) 204, and a lead frame 206. Additionally the fourth example semiconductor device 900 includes a first set of structures 908 (e.g. two package add-on regions), a dielectric layer 210, and a second set of structures 912 (e.g. two sets of existing metal regions on the IC 204).

The first set of structures 908, the dielectric layer 210, and the second set of structures 912 may individually or each include one or more sub-elements. For example, in this example embodiment the first set of structures 908 includes first and second add-on regions 908-A, 908-B, and the second set of structures 912 includes two sets of two metal regions 912-A, 912-B.

The first set of structures 908-A, 908-B, the dielectric layer 210, and the second set of structures 912-A, 912-B together form a set of degradation detection elements 914 (i.e. first capacitor 914-A, second capacitor 914-B).

The fourth example semiconductor device 900 with degradation monitoring otherwise operates in a manner similar to the first example semiconductor device 200 discussed in Figure 2.

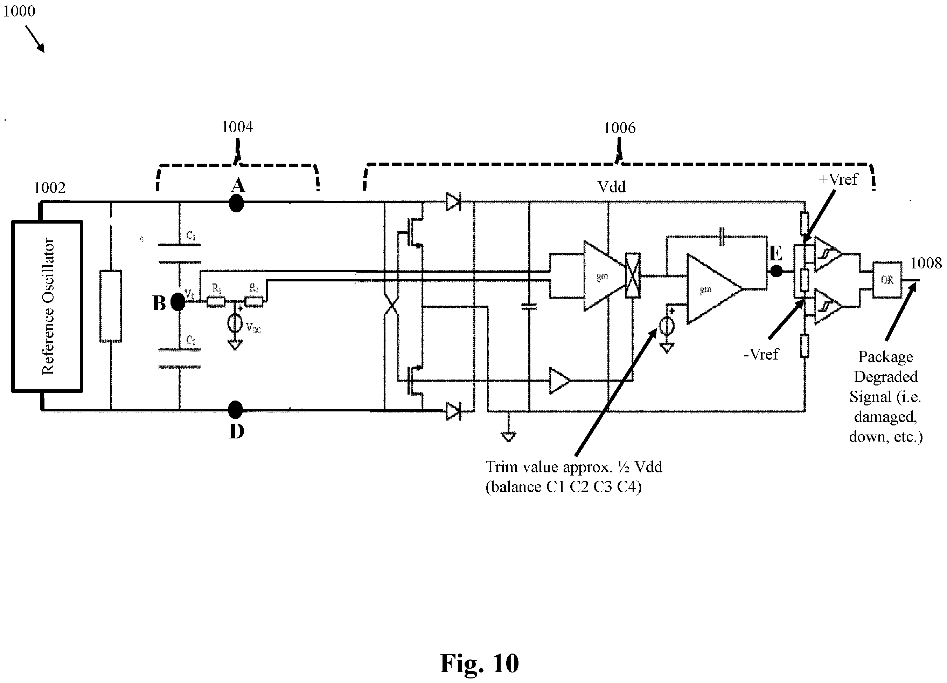

Figure 10 represents an example degradation circuit 1000 within the fourth example semiconductor device 900. Shown is a first portion of the degradation circuit 1000 and includes a reference oscillator 1002, Wheatstone Bridge circuit 1004 (showing connection points A, B, D with reference to Figure 9), degradation detection circuitry 1006, and a first output 1008. The first output 1008 is configured to carry a binary package degraded signal (i.e. damaged, down, etc.).

The first portion of the degradation circuit 1000 may also be connected to a second portion of the degradation circuit 1000 at point "E" but while not shown is substantially similar to the circuit shown in Figure 5B. This second portion also includes a second output configured to carry a variable package degraded signal that gives an earlier warning that an ID and/or package is beginning to degrade, and can be used for IC/package life-cycle prediction if the variable package degraded signal is periodically stored over time.

Various instructions and/or steps discussed in the above Figures can be executed in any order, unless a specific order is explicitly stated. Also, those skilled in the art will recognize that while some example sets of instructions/steps have been discussed, the material in this specification can be combined in a variety of ways to yield other examples as well, and are to be understood within a context provided by this detailed description.

In some example embodiments these instructions/steps are implemented as functional and software instructions. In other embodiments, the instructions can be implemented either using logic gates, application specific chips, firmware, as well as other hardware forms.

When the instructions are embodied as a set of executable instructions in a non-transitory computer-readable or computer-usable media which are effected on a computer or machine programmed with and controlled by said executable instructions. Said instructions are loaded for execution on a processor (such as one or more CPUs). Said processor includes microprocessors, microcontrollers, processor modules or subsystems (including one or more microprocessors or microcontrollers), or other control or computing devices. A processor can refer to a single component or to plural components. Said computer-readable or computer-usable storage medium or media is (are) considered to be part of an article (or article of manufacture). An article or article of manufacture can refer to any manufactured single component or multiple components. The non-transitory machine or computer-usable media or mediums as defined herein excludes signals, but such media or mediums may be capable of receiving and processing information from signals and/or other transitory mediums.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

## Claims

1. A degradation circuit, comprising:
a first set of structures configured to be coupled to a semiconductor package;
a second set of structures, coupled to the first set of structures, and configured to be coupled to the package;
wherein together the first and second set of structures form a Wheatstone bridge within a degradation detection element; and
a controller, coupled to the degradation detection element, and configured to set an operational state of an integrated circuit (IC) within the package based on the degradation detection element.

2. The degradation circuit of claim 1:
wherein the controller is configured to set the operational state of the IC to fully functional if the degradation detection element indicates a value is within a first predetermined range.

3. The degradation circuit of claim 1 or claim 2:
wherein the controller is configured to set the operational state of the IC to partially functional if the degradation detection element indicates the value is within a second predetermined range.

4. The degradation circuit according to any preceding claim:
wherein the controller is configured to set the operational state of the IC to non-functional if the degradation detection element indicates the value is within a third predetermined range.

5. The degradation circuit according to any preceding claim:
wherein the Wheatstone bridge includes a set of four capacitors formed by the first set of structures and the second set of structures.

6. The degradation circuit according to any preceding claim:
wherein the degradation detection element includes a dielectric layer coupled between the first and second set of structures;
wherein the first set of structures is a first metal region; and
wherein the second set of structures is a second metal region.

7. The degradation circuit according to any preceding claim:
wherein the controller is configured to set the operational state of the IC only while the IC is powered and actively operating.

8. The degradation circuit according to any preceding claim:
wherein the controller is configured to select a remediation action for the IC based on the operational state.

9. The degradation circuit of claim 8:
wherein the remediation action includes shutting down a sub-set of circuits within the IC.

10. The degradation circuit of claim 8:
wherein the remediation action includes shutting down a first set of functionality within the IC and keeping a second set of functionality within the IC operating.

11. The degradation circuit of claim 8:
wherein the remediation action includes shutting down the IC's command and control functionality while keeping the IC's collection and transmission of sensor data operating.

12. The degradation circuit of claim 8:
wherein the remediation action includes executing a power on reset (POR) of the IC.

13. The degradation circuit of claim 8:
wherein the remediation action includes activating a set of self-healing circuits within the IC that are configured to repair the detected degradation; and
wherein the self-healing circuits include a self-healing circuit configured to heat the IC and melt a self-healing material.

14. The degradation circuit of claim 8:
wherein the remediation action includes at least one of: transmitting the operational state to a set of devices networked with the IC; activating a back-up circuit in the IC; and activating a set of enhanced IC monitoring tools.

15. The degradation circuit according to any preceding claim:
wherein the second set of structures includes a set of sub-structures;
wherein the set of sub-structures are coupled to different portions of the IC;
wherein together the first and the set of sub-structures form a set of degradation detection elements; and
wherein the controller is coupled to the set of degradation detection elements, and is configured to set an operational state for each of the different portions of the IC based on the set of degradation detection elements.
